# EUROPEAN PATENT SPECIFICATION

(11) **EP 4 742 858 B1**
(45) Date of publication and mention of the grant of the patent: **04.11.2026**
(21) Application number: 25163930.8
(22) Date of filing: 14.03.2025
(51) Int. Cl.: H10F 10/14, H10F 77/20, H10F 77/30

(54) **BACK CONTACT SOLAR CELL AND PHOTOVOLTAIC MODULE**
RÜCKSEITENKONTAKTIERTE SOLARZELLE UND FOTOVOLTAISCHES MODUL
CELLULE SOLAIRE À CONTACT ARRIÈRE ET MODULE PHOTOVOLTAÏQUE

(30) Priority: 11.11.2024 CN 202411604081
(43) Date of publication of application: 13.05.2026
(60) Divisional application: 26199508.8 / 4 819 803
(73) Proprietor: JINKO SOLAR CO., LTD, ShangRao, Jiangxi 334100 (CN); Jinko Solar (Haining) Co., Ltd., Haining City, Zhejiang 314415 (CN)
(72) Inventor: CHEN, Yubin, Shangrao, 334100 (CN); XIA, Danwei, Shangrao, 334100 (CN); XIA, Zhipeng, Shangrao, 334100 (CN); HUANG, Jide, Shangrao, 334100 (CN); LIU, Changming, Shangrao, 334100 (CN)
(74) Representative: Haseltine Lake Kempner LLP

(56) References cited:
- EP-A1- 4 456 152
- CN-A- 118 899 350
- CN-U- 218 827 167
- CN-U- 220 585 238

## Description

### TECHNICAL FIELD

The present disclosure relates to the technical field of photovoltaic cells, and in particular to a back contact solar cell and a photovoltaic module.

### BACKGROUND

A solar cell, also known as a "solar chip" or "photovoltaic cell," is a photoelectric semiconductor device that utilizes sunlight to generate electricity directly. The solar cell can instantly output voltage and generate current in the case of a loop, as long as it is exposed to light that meets certain illuminance conditions.

An interdigitated back contact (IBC) solar cell has no metal grid lines on its front surface, with positive and negative metal electrodes disposed in an interdigitated pattern on its back surface. The IBC solar cell exhibits a good photoelectric conversion efficiency due to the absence of obstruction from the grid lines on its front surface. However, during the process of printing the metal grid lines on the cell wafers and conveying the cell wafers to an assembling process, the front films of the cell wafers are prone to damage. Currently, an isolation paper is commonly interposed between two adjacent cell wafers. However, in the sorting and collecting process, the risk of scratching the front films of the cell wafers is still increased due to uneven collection of the cell wafers or misalignment of the isolation paper.

CN118899350A describes a photovoltaic module
CN220585238U describes a back contact battery.
CN218827167U describes a back-contact cell.
EP4456152A1 describes a back-contact photovoltaic module and a manufacturing method thereof.

### SUMMARY

In view of this, the present disclosure provides a back contact solar cell and a photovoltaic module, to solve the problem that during the process of printing the metal grid lines on the cell wafers and conveying the cell wafers to an assembling process, the front films of the cell wafers are prone to damage.

In a first aspect, the present disclosure provides a back contact solar cell, including a silicon substrate, a first passivation layer, a protective layer, a first electrode, and a second electrode. The silicon substrate has a first surface and a second surface opposite to each other. A P-type conductive section and an N-type conductive section spaced apart from each other are provided at a side of the second surface of the silicon substrate. The first passivation layer is disposed on the first surface of the silicon substrate. The protective layer is disposed on a side of the first passivation layer facing away from the silicon substrate. The protective layer includes a plurality of support members spaced apart from each other and disposed on the side of the first passivation laye facing away from the silicon substrate. The first electrode is electrically connected to the P-type conductive section. The second electrode is electrically connected to the N-type conductive section. A cross-sectional shape of the support member, perpendicular to the thickness direction of the back contact solar cell, is a strip shape formed by combining a semicircular shape and a rectangular shape. The semicircular shape has a radius of R₂, where 0 < R₂ ≤ 2 mm. The rectangular shape has a length of L, where 1 ≤ L/R₂ ≤ 5.

In an embodiment, in a thickness direction of the back contact solar cell, a projected area of the protective layer is 2% to 3% of a projected area of the silicon substrate.

In an embodiment, the protective layer has a thickness of H₁, where 5 µm ≤ H₁ ≤ 60 µm.

In an embodiment, a distance between geometric centers of any two adjacent support members is d, where 0 < d ≤ 20 mm.

In an embodiment, the protective layer is a transparent protective layer.

In an embodiment, a material of the protective layer is acrylic resin, epoxy resin, polyurethane, silicone, or any combination thereof.

In a second aspect, the present disclosure provides a photovoltaic module. The photovoltaic module includes a cell string, an encapsulation layer, and a cover plate. The cell string is formed by a plurality of back contact solar cells that are provided according to any one of the above embodiments and connected to each other. The encapsulation layer is configured to cover a surface of the protective layer of each of the plurality of back contact solar cells of the cell string. The cover plate is configured to cover a surface of the encapsulation layer that is away from the cell string.

In the present disclosure, the protective layer is disposed on a side of the first passivation layer facing away from the first surface of the silicon substrate. The protective layer can prevent the contact between a surface of the first passivation layer and other stacked back contact solar cells or other objects, so that during the sorting and collecting process or the assembling process of the photovoltaic module after the first electrode and the second electrode of the back contact solar cell are printed, the protective layer can protect the first passivation layer from being scratched or damaged by other objects, thereby ensuring the passivation effect of the first passivation layer on the first surface and improving the photoelectric conversion efficiency of the back contact solar cell.

Additionally, since the protective layer is directly disposed on the side of the first passivation layer facing away from the silicon substrate and cannot move relative to the surface of the first passivation layer, the protective layer can still well protect the surface of the first passivation layer even when multiple back contact solar cells are stacked unevenly, without the need to additionally add an isolation component between every two adj acent back contact solar cells during the sorting and collecting process, which can improve the sorting and collecting efficiency of the multiple back contact solar cells. In addition, the back contact solar cell is simple in structure, easy to manufacture, and low in manufacturing cost.

### BRIEF DESCRIPTION OF THE DRAWINGS

FIG. 1 is a schematic cross-sectional view of a back contact solar cell in a specific embodiment of the present disclosure;
FIG. 2 is a schematic cross-sectional view of a back contact solar cell in another specific embodiment of the present disclosure;
FIG. 3 is a partial schematic view of a back contact solar cell according to the present disclosure;
FIG. 4 is a top view of a back contact solar cell in a specific embodiment of the present disclosure;
FIG. 5 is a partial enlarged view of a position A in FIG. 4;
FIG. 6 is a top view of a back contact solar cell in another specific embodiment of the present disclosure;
FIG. 7 is a partial enlarged view of a position B in FIG. 6; and
FIG. 8 is a schematic structural view of a photovoltaic module according to the present disclosure.

Reference numerals:
100-back contact solar cell;
1-silicon substrate;
11-first surface;
12-second surface;
121-P-type conductive section;
122-N-type conductive section;
2-first electrode;
3-second electrode;
4-protective layer;
   41-support member;
5-first passivation layer;
6-first doped conductive layer;
7-second doped conductive layer;
8-second passivation layer;
9-anti-reflection layer;
10a-first tunneling dielectric layer;
10b-second tunneling dielectric layer;
110-cell string;
120-encapsulation layer;
130-cover plate;
X-first direction
Y-second direction; and
Z-thickness direction.

### DETAILED DESCRIPTION

In the description of the present disclosure, unless otherwise expressly specified and defined, the terms "first" and "second" are only used for descriptive purposes, and cannot be understood as indicating or implying relative importance. Unless otherwise specified or stated, the term "a plurality of" refers to two or more. The terms such as "connected" and "fixed" should be understood broadly. For example, "connected" may be fixedly connected, or may be detachably connected, or integrally connected, or electrically connected; or, "connected" may be directly connected or indirectly connected through an intermediate medium. Those of ordinary skill in the art should understand specific meanings of the above terms in the present disclosure according to specific situations.

The terms used in the embodiments of the present disclosure are merely used for describing the specific embodiments rather than limiting the present disclosure. Singular forms including "a", "an", and "the" used in the embodiments and claims of the present disclosure are also intended to include a plural form, except that the context clearly expresses other meanings.

It should be understood that the term "and/or" used herein is merely a description of an association relationship between associated objects, indicating that there may be three relationships. For example, A and/or B may represent: A exists alone, A and B exist together, or B exists alone. In addition, the character "/" herein generally means that the associated objects before and after it are in an "or" relationship.

It should be noted that the directional terms such as "up", "down", "left", and "right" described in the embodiments of the present disclosure are described based on the angle shown in the accompanying drawings and should not be construed as limiting the embodiments of the present disclosure. In addition, in the context, it should also be understood that when it is mentioned that one element is connected "on" or "below" the other element, it may be directly connected "on" or "below" the other element, or it may be indirectly connected "on" or "below" the other element through an intermediate element.

An interdigitated back contact (IBC) solar cell has no metal grid lines on its front surface, with positive and negative metal electrodes disposed in an interdigitated pattern on its back surface. The IBC solar cell exhibits a good photoelectric conversion efficiency due to the absence of obstruction from the grid lines on its front surface. However, during the process of printing the metal grid lines on the cell wafers and conveying the cell wafers to an assembling process, the cell wafers are stacked with each other, and the front films of the cell wafers are prone to damage. Currently, a spacer paper is commonly interposed between two adjacent cell wafers. However, in the sorting and collecting process, the risk of scratching the front films of the cell wafers is still increased due to uneven collection of the cell wafers or misalignment of the spacer paper.

In view of this, the present disclosure provides a back contact solar cell and a photovoltaic module. The back contact solar cell includes, but is not limited to, an interdigitated back contact (IBC) solar cell, a hybrid passivated back contact (HPBC) solar cell, a tunneling oxide passivated contact back contact (TBC) solar cell, a heterojunction back contact (HBC) solar cell, etc., which is not limited herein.

The present disclosure is further described in detail through specific embodiments with reference to the accompanying drawings.

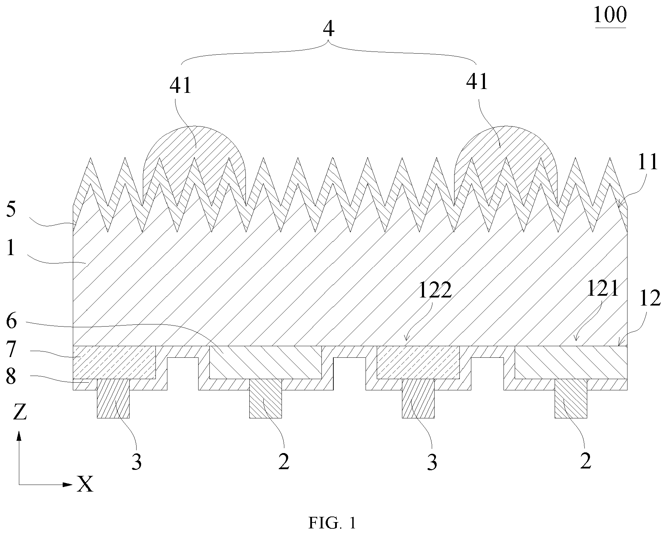

As shown in FIG. 1, the back contact solar cell 100 has a length direction, a width direction, and a thickness direction Z. For ease of understanding, the width direction of the back contact solar cell 100 is defined as a first direction X, and the length direction of the back contact solar cell 100 is defined as a second direction Y.

As shown in FIG. 1, the back contact solar cell 100 includes a silicon substrate 1, a first passivation layer 5, a protective layer 4, a first electrode 2, and a second electrode 3. The silicon substrate 1 has a first surface 11 and a second surface 12 that are opposite to each other. The first passivation layer 5 is disposed on the first surface 11 of the silicon substrate 1. The protective layer 4 is disposed on a side of the first passivation layer 5 facing away from the silicon substrate 1. AP-type conductive section 121 and an N-type conductive section 122 that are spaced apart from each other are provided at a side of the second surface 12 of the silicon substrate 1. The first electrode 2 is electrically connected to the P-type conductive section 121. The second electrode 3 is electrically connected to the N-type conductive section 122.

The silicon substrate 1 is configured to receive incident light and generate photogenerated carriers. The first surface 11 of the silicon substrate 1 serves as a light-receiving surface, namely, a surface exposed to sunlight irradiation. The second surface 12 of the silicon substrate 1 is a surface of the silicon substrate 1 that is opposite to the first surface 11. In some embodiments, the silicon substrate 1 is a silicon-based substrate, which may include monocrystalline silicon, polycrystalline silicon, amorphous silicon, microcrystalline silicon, or any combination thereof. In some other embodiments, a material of the silicon substrate 1 may also be silicon carbide or an organic material. Exemplarily, the silicon substrate 1 in the present disclosure may be a monocrystalline silicon substrate. The silicon substrate 1 may contain a doping element therein. The doping element may have a conductivity type that is either N-type or P-type. An N-type element may be a group V element such as phosphorus (P) element, bismuth (Bi) element, antimony (Sb) element, or arsenic (As) element. A P-type element may be a group III element such as boron (B) element, aluminum (Al) element, gallium (Ga) element, or indium (In) element. For example, when the silicon substrate 1 is a P-type silicon substrate, the doping element in the silicon substrate 1 is of P type. For another example, when the silicon substrate 1 is an N-type silicon substrate, the doping element in the silicon substrate 1 is of N type. As an example in the present disclosure, the silicon substrate 1 is exemplified as an N-type silicon substrate, which can improve the photoelectric conversion efficiency of the back contact solar cell 100 and reduce the manufacturing cost.

The first electrode 2 and the second electrode 3 are configured to collect and aggregate the current in the back contact solar cell 100. Exemplarily, the first electrode 2 and the second electrode 3 may be manufactured using screen printing and sintering methods. In some embodiments, the first electrode 2 and the second electrode 3 may be manufactured from a metal paste of aluminum, silver, gold, nickel, molybdenum, copper, or any combination thereof, which is not limited herein.

The first passivation layer 5 can effectively passivate the first surface 11 of the silicon substrate 1, thereby reducing the interface state density, decreasing the recombination of minority carriers, improving the carrier transport efficiency at the interface, and enhancing the photoelectric conversion efficiency of the back contact solar cell 100. Exemplarily, the first passivation layer 5 may be deposited using a plasma-enhanced chemical vapor deposition method. It should be understood that the first passivation layer 5 may be formed using other methods, such as an organic chemical vapor deposition method. The first passivation layer 5 may be of a single-layer structure or a laminated structure, with a thickness of each layer designed respectively. Specifically, the first passivation layer 5 may be any one of or a combination of any two or more of a silicon nitride layer, a silicon oxynitride layer, a silicon oxide layer, and an aluminum oxide layer. It should be understood that the first passivation layer 5 may also be another type of passivation layer, which is not limited herein.

In the present disclosure, as shown in FIG. 1, the protective layer 4 is disposed on a side of the first passivation layer 5 facing away from the first surface 11 of the silicon substrate 1. The protective layer 4 can prevent the contact between a surface of the first passivation layer 5 and other stacked back contact solar cells 100 or other objects, so that during the sorting and collecting process or the assembling process of the photovoltaic module after the first electrode 2 and the second electrode 3 of the back contact solar cell 100 are printed, the protective layer 4 can protect the first passivation layer 5 from being scratched or damaged by other objects, thereby ensuring the passivation effect of the first passivation layer 5 on the first surface 11 and improving the photoelectric conversion efficiency of the back contact solar cell 100.

Additionally, since the protective layer 4 is directly disposed on the side of the first passivation layer 5 facing away from the silicon substrate 1 and cannot move relative to the surface of the first passivation layer 5, the protective layer 4 can still well protect the surface of the first passivation layer 5 even when multiple back contact solar cells 100 are stacked unevenly, without the need to additionally add an isolation component between every two adjacent back contact solar cells 100 during the sorting and collecting process, which can improve the sorting and collecting efficiency of the multiple back contact solar cells 100. In addition, the back contact solar cell 100 is simple in structure, easy to manufacture, and low in manufacturing cost.

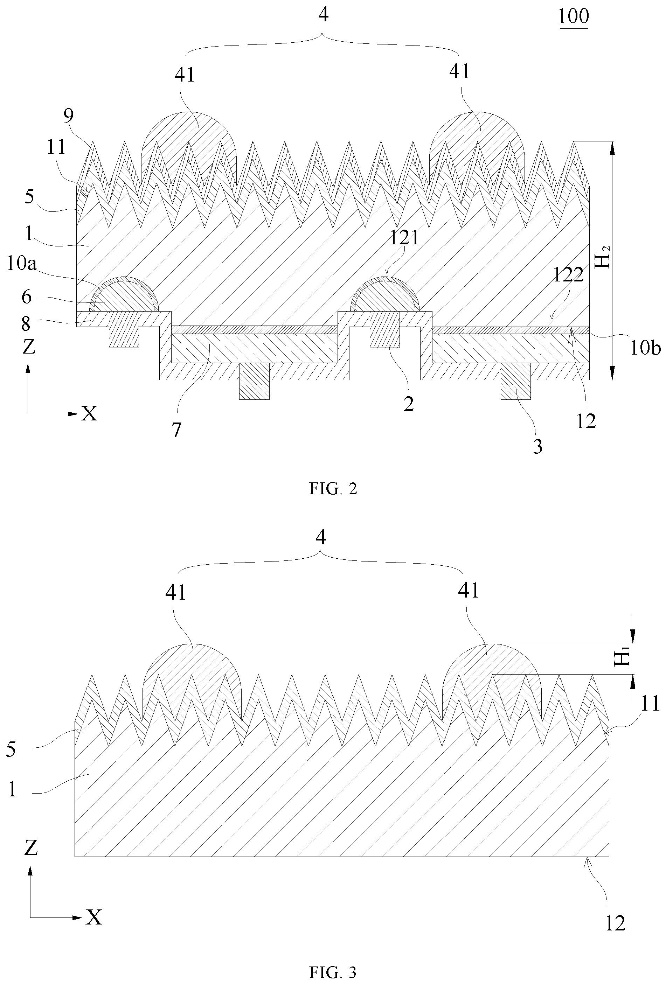

As shown in FIG. 1 and FIG. 2, the back contact solar cell 100 further includes a first doped conductive layer 6, a second doped conductive layer 7, and a second passivation layer 8.

The first doped conductive layer 6 is disposed in the P-type conductive section 121 at the second surface 12 of the silicon substrate 1. The first doped conductive layer 2 may serve as an emitter. The doping element in the first doped conductive layer 2 may be in a different conductivity type from the doping element in the silicon substrate 1. The first doped conductive layer 2 and the silicon substrate 1 may collectively form a PN junction structure. Exemplarily, when the silicon substrate 1 is the N-type silicon substrate, a portion of the silicon substrate 1 at the P-type conductive section 121 may be subjected to boron diffusion to form the first doped conductive layer 6 in P-type.

The second doped conductive layer 7 is disposed in the N-type conductive section 122 at the second surface 12 of the silicon substrate 1. The doping element in the second doped conductive layer 7 is the same as that in the silicon substrate 1, with a concentration gradient formed between the second doped conductive layer 7 and the silicon substrate 1, so that the second doped conductive layer 7 can form a good contact with the second electrode 3 and an energy band bending can be formed at the surface of the N-type conductive section 122, thereby achieving the selective transport of carriers and reducing the recombination losses. The second doped conductive layer 7 may be deposited in the N-type conductive section 122 using any one of a physical vapor deposition method, a chemical vapor deposition method, a plasma-enhanced chemical vapor deposition method, and an atomic layer deposition method.

The second passivation layer 8 is disposed on a side of the first doped conductive layer 6 and a side of the second doped conductive layer 7 that face away from the silicon substrate 1 and disposed on at least a portion of the second surface 12. The second passivation layer 8 can effectively passivate the sides of the first doped conductive layer 6 and the second doped conductive layer 7 facing away from the silicon substrate 1 and the at least a portion of the second surface 12. Exemplarily, the second passivation layer 8 may be deposited using the plasma-enhanced chemical vapor deposition method. It should be understood that the second passivation layer 8 may be deposited using other methods, such as the organic chemical vapor deposition method. The second passivation layer 8 may be of a single-layer structure or a laminated structure, with a thickness of each layer designed respectively. Specifically, the second passivation layer 8 may be any one of or a combination of two or more of a silicon nitride layer, a silicon oxynitride layer, a silicon oxide layer, and an aluminum oxide layer. It should be understood that the second passivation layer 8 may also be another type of passivation layer, which is not limited herein.

The first electrode 2 penetrates through the second passivation layer 8 to be electrically connected to the first doped conductive layer 6. The second electrode 3 penetrates through the second passivation layer 8 to be electrically connected to the second doped conductive layer 7.

It should be noted that as shown in FIG. 1 and FIG. 2, exemplarily, the P-type conductive section 121 or the N-type conductive section 122 may be formed at a side of the second surface 12 of the silicon substrate 1 away from the first surface 11, or exemplarily, the P-type conductive section 121 or the N-type conductive section 122 may be formed at a side of the second surface 12 of the silicon substrate 1 close to the first surface 11, namely, the P-type conductive section 121 or the N-type conductive section 122 may formed inside the silicon substrate 1. It should be understood that the P-type conductive section 121 or the N-type conductive section 122 may also be partially formed at the side of the second surface 12 away from the first surface 11 and partially formed at the side of the second surface 12 close to the first surface 11, which may be specifically set according to actual needs and is not limited herein.

Additionally, as shown in FIG. 2, the back contact solar cell 100 may also include an anti-reflection layer 9. The anti-reflection layer 9 may be disposed between the first passivation layer 5 and the protective layer 4.

The anti-reflection layer 9 may reduce or eliminate the reflection of light on the surface of the back contact solar cell 100 and increase the light transmittance, thereby further improving the photoelectric conversion efficiency of the back contact solar cell 100. The anti-reflection layer 9 may be a silicon nitride layer, which can further reduce the manufacturing difficulty and improve the manufacturing efficiency of the back contact solar cell 100. It should be understood that the anti-reflection layer 9 may alternatively be a silicon oxynitride layer, or a single-layer or laminated structure composed of silicon nitride and silicon oxynitride, or other anti-reflection film structure, which is not limited herein.

In a specific embodiment, as shown in FIG. 2, the back contact solar cell 100 may further include a first tunneling dielectric layer 10a and a second tunneling dielectric layer 10b. The first tunneling dielectric layer 10a is disposed between the first doped conductive layer 6 and the silicon substrate 1. The second tunneling dielectric layer 10b is disposed between the second doped conductive layer 7 and the silicon substrate 1.

As shown in FIG. 2, through the chemical passivation, the first tunneling dielectric layer 10a and the second tunneling dielectric layer 10b can reduce the state density at the interface between the silicon substrate 1 and the first doped conductive layer 6 and at the interface between the silicon substrate 1 and the second doped conductive layer 7, reduce the recombination of the minority carriers with holes, and improve the passivation effect on the surface of the silicon substrate 1. The first tunneling dielectric layer 10a and the second tunneling dielectric layer 10b can also allow majority carriers to tunnel into the first doped conductive layer 6 and the second doped conductive layer 7, thereby enabling the transverse transport of the majority carriers in the first doped conductive layer 6 and the second doped conductive layer 7, which facilitates the carrier collection by the first electrode 2 and the second electrode 3 and facilitates the improvement of the open-circuit voltage and short-circuit current of the back contact solar cell 100. Additionally, the first tunneling dielectric layer 10a and the second tunneling dielectric layer 10b may also form passivated contact structures with the first doped conductive layer 6 and the second doped conductive layer 7, respectively, thereby achieving excellent interface passivation and selective carrier collection, and improving the photoelectric conversion efficiency of the back contact solar cell 100.

A material of the first tunneling dielectric layer 10a or the second tunneling dielectric layer 10b may include, but is not limited to, a dielectric material having a tunneling effect, such as silicon oxide, silicon nitride, silicon oxynitride, molybdenum oxide, hafnium oxide, silicon carbide, magnesium fluoride, nanocrystalline silicon, intrinsic amorphous silicon, intrinsic polycrystalline silicon, or any combination thereof. The first tunneling dielectric layer 10a or the second tunneling dielectric layer 10b may be a single-layer or a laminated structure made of one or more of the above dielectric materials. In other embodiments, the first tunneling dielectric layer 10a or the second tunneling dielectric layer 10b may also be an oxygen-containing silicon nitride layer, an oxygen-containing silicon carbide layer, and the like, which is not limited herein. In some embodiments, the tunneling layer may be formed at a side of the second surface 12 of the silicon substrate 1 using methods such as an ozone oxidation method, a high-temperature thermal oxidation method, a nitric acid oxidation method, a chemical vapor deposition method, and a low-pressure chemical vapor deposition method.

In a specific embodiment, as shown in FIG. 3, the protective layer 4a has a thickness of H₁, where 5 µm ≤ H₁ ≤ 60 µm. For example, the thickness H₁ of the protective layer 4 may be 5 µm, 10 µm, 15 µm, 20 µm, 25 µm, 30 µm, 35 µm, 40 µm, 45 µm, 50 µm, 55 µm, 60 µm, etc. It should be understood that the thickness H₁ of the protective layer 4 may also be other values within the above range, and may be specifically designed according to actual needs, which is not limited herein.

In this embodiment, as shown in FIG. 1 to FIG. 3, if the thickness H₁ of the protective layer 4 is too large, for example, H₁> 60 µm, the overall thickness of the back contact solar cell 100 would be increased, and the manufacturing cost of the back contact solar cell 100 wound be raised. Additionally, during assembling the photovoltaic module, the too large thickness H₁ of the protective layer 4 tends to reduce the fit of the back contact solar cell 100 with other components, increase the difficulty of providing a film structure such as an encapsulation layer on the surface of the back contact solar cell 100, and increase the difficulty of assembling the photovoltaic module. If the thickness H₁ of the protective layer 4 is too small, for example, H₁ < 5 µm, the protective and isolation effect of the protective layer 4 would be inadequate, resulting in a risk of scratching or damaging the surface of the first passivation layer 5 when multiple back contact solar cells 100 are stacked with each other.

Therefore, when the thickness H₁ of the protective layer 4 satisfies 5 µm ≤ H₁ ≤ 60 µm, the thickness of the protective layer 4 is appropriate to provide a high protective and isolation effect and prevent the surface of the first passivation layer 5 from being scratched and damaged, with a low manufacturing cost and an easy manufacturing and forming process, which is conductive to the batch production of the back contact solar cell 100 and the assembly and formation of the photovoltaic module.

Further, as shown in FIG. 1 and FIG. 2, a maximum thickness H₂ between a surface of the second passivation layer 8 facing away from the silicon substrate 1 and a surface of the first passivation layer 5 or the anti-reflection layer 9 facing away from the silicon substrate 1 in the back contact solar cell 100, namely, the sum of maximum thicknesses of all films in the back contact solar cell 100 in addition to the protective layer 4, the first electrode 2, and the second electrode 3, may range from 90 µm to 210 µm to improve the design flexibility of the back contact solar cell 100, which may be specifically set according to actual needs and is not limited herein.

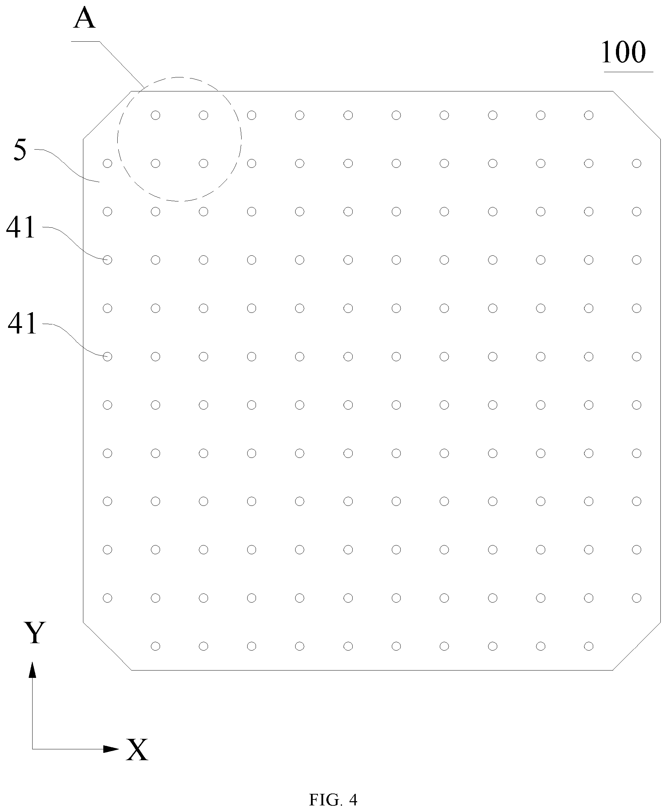

In a specific embodiment, as shown in FIG. 4, in the thickness direction Z of the back contact solar cell 100, a projected area of the protective layer 4 is 2% to 3% of a projected area of the silicon substrate 1. For example, the projected area of the protective layer 4 may be 2%, 2.1%, 2.2%, 2.3%, 2.4%, 2.5%, 2.6%, 2.7%, 2.8%, 2.9%, 3%, etc. of the projected area of the silicon substrate 1, and may also be other values within the above range, which may be specifically set according to actual needs and is not limited herein.

As shown in FIG. 1 and FIG. 4, if the projected area of the protective layer 4 is too large, for example, greater than 3% of the projected area of the silicon substrate 1, the absorption of light by the silicon substrate 1 may be affected, resulting in a significant optical loss, a high current loss, and a potential decrease in the photoelectric conversion efficiency of the back contact solar cell 100. Exemplarily, when the projected area of the protective layer 4 is greater than 5% of the projected area of the silicon substrate 1, the current loss is greater than 50 mA, leading to a decrease in the photoelectric conversion efficiency of the back contact solar cell 100.

If the projected area of the protective layer 4 is too small, for example, less than 2% of the projected area of the silicon substrate 1, a larger area of the first passivation layer 5 is exposed, so that when two adjacent back contact solar cells 100 are stacked unevenly or misaligned from each other, there is a risk of scratching or damaging the surface of the first passivation layer 5, and the protective layer 4 has a poor protective and isolation effect.

In the embodiment as shown in FIG. 4, when the projected area of the protective layer 4 is 2% to 3% of the projected area of the silicon substrate 1, the influence of the protective layer 4 on the light absorption of the silicon substrate 1 is small, resulting in a low optical loss and a low current loss. In this embodiment, when the projected area of the protective layer 4 is 2% to 3% of the projected area of the silicon substrate 1, the current loss is less than 30 mA. Additionally, the protective layer 4 has a good protective and isolation effect, and can prevent the first passivation layer 5 and other films on the first surface 11 of the silicon substrate 1 from being scratched and damaged, thereby ensuring that the back contact solar cell 100 has a high photoelectric conversion efficiency.

In a specific embodiment, the protective layer 4 is a transparent protective layer, allowing light to pass through the protective layer 4 and reach the first surface 11, which can further reduce the optical loss and improve the photoelectric conversion efficiency of the back contact solar cell 100.

In a specific embodiment, a material of the protective layer 4 is any one of or a combination of two or more of acrylic resin, epoxy resin, polyurethane, and silicone.

The material such as the acrylic resin, the epoxy resin, the polyurethane, and the silicone has a high transparency, a good light and color retention, a water and chemical resistance, and a low cost, and is unlikely to cause damage to the first passivation layer 5 and other films on the first surface 11 or to the back contact solar cell 100 in contact with the material, thereby further reducing the optical loss and saving the cost.

In a specific embodiment, as shown in FIG. 4 to FIG. 7, the protective layer 4 includes a plurality of support members 41 spaced apart from each other and disposed on the side of the first passivation layer 5 facing away from the silicon substrate 1.

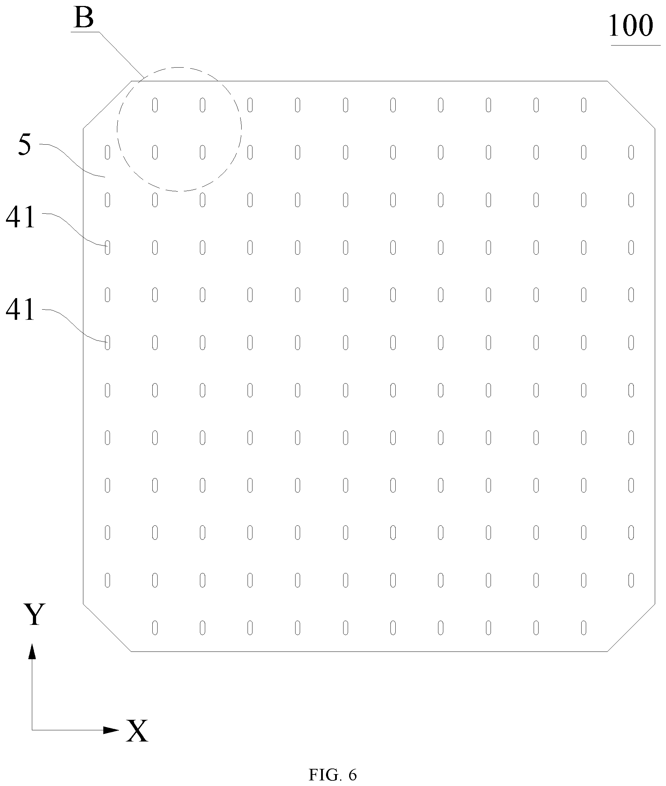

In this embodiment, as shown in FIG. 4 and FIG. 6, the support members 41 may keep a distance between the first passivation layer 5 disposed on the first surface 11 and other stacked back contact solar cells 100 or other objects, thereby preventing the surface of the first passivation layer 5 from coming into contact with other objects and being scratched and damaged. Moreover, the plurality of support members 41 collectively form the protective layer, which enables the protective layer 4 to be uniformly disposed on the side of the first passivation layer 5 facing away from the silicon substrate 1, so that the protective layer 4 can provide a uniform supporting force to objects stacked on the surface thereof, thereby reducing the likelihood of their relative slippage, ensuring the stability of the stack of a plurality of back contact solar cells 100, and further reducing the risk of scratching or damaging the first passivation layer 5 and other films on the first surface 11. Additionally, the formation of the protective layer 4 by the plurality of support members 41 can further reduce the projected area of the protective layer 4 on the silicon substrate 1, thereby further reducing the optical loss of the back contact solar cell 100 while ensuring the high protective and isolation effect of the protective layer 4.

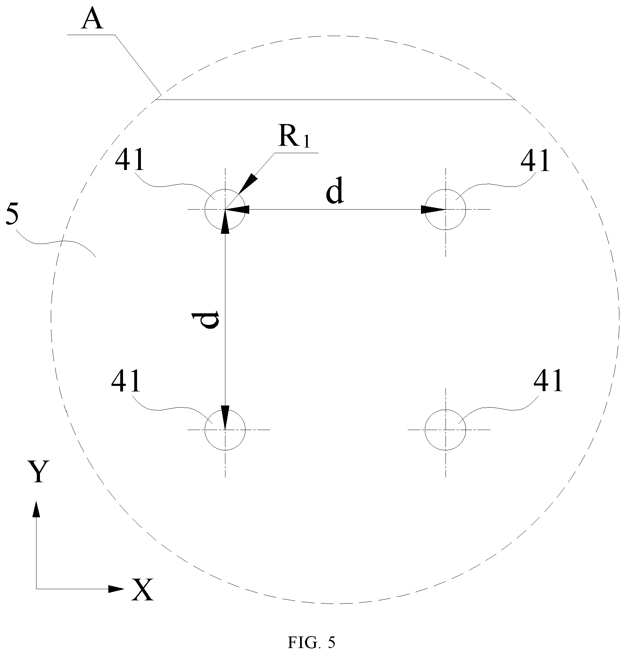

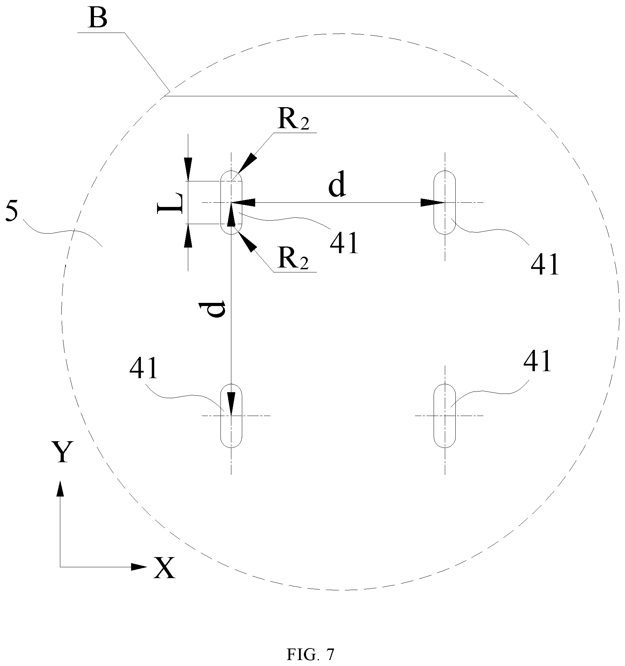

In a specific embodiment, as shown in FIG. 5 and FIG. 7, a distance between geometric centers of any two adjacent support members 41 is d, where 0 < d ≤ 20 mm. For example, the distance d between the geometric centers of any two adjacent support members 41 may be 1 mm, 2 mm, 3 mm, 4 mm, 5 mm, 6 mm, 7 mm, 8 mm, 9 mm, 10 mm, 11 mm, 12 mm, 15 mm, 18 mm, 20 mm, etc. It should be understood that the distance d between the geometric centers of any two adjacent support members 41 may also be other values within the above range, which may be specifically set according to actual needs and is not limited herein.

As shown in FIG. 4 to FIG. 7, if the distance d between the geometric centers of any two adjacent support members 41 is too large, for example, d > 20 mm, then any two adjacent support members 41 would be too far apart, increasing the likelihood that the back contact solar cells 100 or other objects stacked on the protective layer 4 may come into contact with and scratch or damage the first passivation layer 5 and other film structures disposed on the first surface 11 through the gap between the two adjacent support members 41.

In this embodiment, as shown in FIG. 4 to FIG. 7, when the distance d between the geometric centers of two adjacent support members 41 satisfies 0 < d ≤ 20 mm, then any two adjacent support members 41 would be appropriately apart such that it is difficult for the back contact solar cells 100 or other objects stacked on the protective layer 4 to extend into the gap between two adjacent support members 41, thereby further improving the protective and isolation effect of the protective layer 4, preventing the contact between the back contact solar cells 100 or other objects with the first passivation layer 5 and other film structures on the first surface 11, and reducing the risk of scratching or damaging the first passivation layer 5 and other film structures on the first surface 11.

In a specific embodiment, a cross-sectional shape of the support member 41, perpendicular to the thickness direction Z of the back contact solar cell 100, is a circular shape, a semicircular shape, an annular shape, a rectangular shape, a triangular shape, a rhombic shape, a W shape, a V shape, or any combination thereof. Such a structure is simple, facilitating the manufacture of the protective layer 4, and improving the design flexibility of the back contact solar cell 100.

It should be understood that the cross-sectional shape of the support member 41 may also be a pentagonal shape, a hexagonal shape, or an irregular shape, which may be specifically set according to actual needs and is not limited herein.

In a specific embodiment, as shown in FIG. 4 and FIG. 5, the cross-sectional shape of the support member 41 perpendicular to the thickness direction Z of the back contact solar cell 100, i.e., in a plane of the first direction X and the second direction Y, is a circular shape. Such a structure is simple and easy to manufacture, further reducing the manufacture difficulty and saving the cost of the protective layer 4.

As shown in FIG. 4 and FIG. 5, a radius of the circular shape is R₁, where 0 < R₁ ≤ 4 mm. For example, R₁ may be 0.5 mm, 0.75 mm, 0.8 mm, 1 mm, 1.2 mm, 1.5 mm, 1.6 mm, 1.8 mm, 2 mm, 2.5 mm, 3 mm, 3.5 mm, 4 mm, etc. It should be understood that the radius R₁ of the circular shape may also be other values within the above range, which may be specifically set according to actual needs and is not limited herein.

When the cross-sectional shape of the support member 41 is the circular shape, and a plurality of the support members 41 are arranged as shown in FIG. 4, the projected area S of the protective layer 4 may be calculated through the formula $S = {{πR}_{1}}^{2} ∗ \left(\frac{M}{{d}^{2}}\right)$. In the formula, S denotes the projected area of the protective layer 4 in mm²; R₁ denotes the cross-sectional radius of each support member 41 in mm; M denotes the projected area of the silicon substrate 1 in the thickness direction Z in mm²; and d denotes the distance between the geometric centers of two adjacent support members 41 in mm.

According to the formula $S = {{πR}_{1}}^{2} ∗ \left(\frac{M}{{d}^{2}}\right)$, it can be seen that the projected area S of the protective layer 4 is directly proportional to the cross-sectional radius R₁ of the support member 41. Therefore, if R₁ is too large, the projected area of single support member 41 is relatively large, so that the projected area S of the protective layer 4 tends to be too large, which is likely to increase the optical loss of the back contact solar cell 100, and consequently reduce the photoelectric conversion efficiency of the back contact solar cell 100.

Therefore, when the cross-sectional shape of the support member 41 is the circular shape and the radius R₁ of the circular shape satisfies 0 < R₁ ≤ 4 mm, the projected area of single support member 41 will not be too large, while the support member 41 can have a certain supporting force, allowing the protective layer 4 to have a good protective and isolation effect. Additionally, such structure configuration can avoid too large projected area S of the protective layer 4, thereby reducing the optical loss caused by the protective layer 4 and ensuring that the back contact solar cell 100 can have high photoelectric conversion efficiency.

In another specific embodiment, as shown in FIG. 6 and FIG. 7, the cross-sectional shape of the support member 41 perpendicular to the thickness direction Z of the back contact solar cell 100, i.e., in a plane of the first direction X and the second direction Y, is a strip shape formed by combining a semicircular shape with a rectangular shape. The support member 41 of such structure has the advantages of simple structure, easy manufacture, and improved support effect.

Specifically, the support member 41 is in a strip cross-sectional shape formed by a rectangular shape with two semicircular shapes disposed at two opposite ends of the rectangular shape. Exemplarily, as shown in FIG. 7, the two semicircular shapes are disposed on two opposite sides of the rectangular shape in the second direction Y, and a width size of the rectangular shape in the first direction X is the same as a diameter of the semicircular shapes.

As shown in FIG. 6 and FIG. 7, a radius of each semicircular shape in the cross-sectional shape of the support member 41 is R₂, where 0 < R₂ ≤ 2 mm. For example, R₂ may be 0.5 mm, 0.75 mm, 0.8 mm, 1 mm, 1.2 mm, 1.5 mm, 1.6 mm, 1.8 mm, 2 mm, etc. It should be understood that the radius R₂ of each semicircular shape may also be other values within the above range, which may be specifically set according to actual needs and is not limited herein.

A length of the rectangular shape in the cross-sectional shape of the support member 41 is L, where 1 ≤ L/R₂ ≤ 5. For example, L/R₂ may be 1, 2, 3, 4, 5, etc. It should be understood that L/R₂ may also be other values within the above range, which is not limited herein.

When the cross-sectional shape of the support member 41 is the strip shape, and a plurality of the support members 41 are arranged as shown in FIG. 6, the projected area S of the protective layer 4 may be calculated through the formula $S = \left({{πR}_{2}}^{2}+{2 R}_{2}∗L\right) ∗ \left(\frac{M}{{d}^{2}}\right)$. In the formula, S denotes the projected area of the protective layer 4 in mm²; R₂ denotes the radius of each semicircular shape in the cross-sectional shape of the support member 41 in mm; L denotes the length L of the rectangular shape in the cross-sectional shape of the support member 41 in mm; M denotes the projected area of the silicon substrate 1 in the thickness direction Z in mm²; and d denotes the distance between the geometric centers of two adjacent support members 41 in mm.

According to the formula $S = \left({{πR}_{2}}^{2}+{2 R}_{2}∗L\right) ∗ \left(\frac{M}{{d}^{2}}\right)$, it can be seen that the projected area S of the protective layer 4 is directly proportional to the radius R₂ of each semicircular shape and the length L of the rectangular shape in the cross-sectional shape of the support member 41. Therefore, if R₂ and L are too large, the projected area of single support member 41 would be relatively large, so that the projected area S of the protective layer 4 tends to be too large, which is likely to increase the optical loss of the back contact solar cell 100, and consequently reduce the photoelectric conversion efficiency of the back contact solar cell 100.

Therefore, when the cross-sectional shape of the support member 41 is the strip shape formed by combining the semicircular shapes and the rectangular shape, the radius R₂ of each semicircular shape in the cross-sectional shape satisfies 0 < R₂ ≤ 2mm, and the length L of the rectangular shape in the cross-sectional shape satisfies 1 ≤ L/R₂ ≤ 5, the projected area of single support member 41 will not be too large, while the support member 41 can have a larger supporting force, allowing the protective layer 4 to have a good protective and isolation effect. Additionally, such structure configuration can avoid too large projected area S of the protective layer 4, thereby reducing the optical loss caused by the protective layer 4 and ensuring that the back contact solar cell 100 can have high photoelectric conversion efficiency.

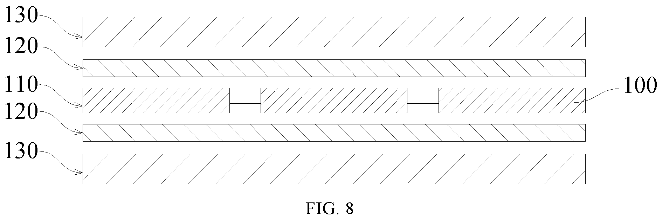

In a second aspect, the present disclosure provides a photovoltaic module. As shown in FIG. 8, the photovoltaic module includes at least one cell string 110, at least one encapsulation layer 120, and at least one cover plate 130. The cell string 110 is formed by a plurality of back contact solar cells 100 that are provided according to any one of the embodiments described above and connected to each other. The at least one encapsulation layer 120 is configured to cover the surfaces of the protective layers 4 of the cell string 110. The cover plate 130 is configured to cover a surface of the encapsulation layer 120 that is away from the cell string 110. Since the back contact solar cell 100 has the above technical effects, the photovoltaic module that includes the solar cells 100 should also have the above technical effects, and further elaboration is unnecessary herein.

As shown in FIG. 8, the back contact solar cells 100 may be electrically connected in whole or in pieces to form a plurality of cell strings 110. The plurality of cell strings 110 may be electrically connected in series and/or in parallel. Specifically, the plurality of cell strings 110 may be electrically connected through conductive tapes.

The front surfaces and the back surfaces of the back contact solar cells are covered by the at least one encapsulation layer 120. Specifically, the encapsulation layer 120 may be an organic encapsulation film such as an ethylene-vinyl acetate (EVA) film, a polyethylene octene elastomer (POE) film, a polyethylene terephthalate (PET) film, or a polyvinyl butyral (PVB) film.

The cover plate 130 may be a glass cover plate, a plastic cover plate, or any other cover plate 130 with a light transmitting function. Specifically, a surface of the cover plate 130 facing towards the encapsulation layer 120 may be a concave-convex surface to increase the utilization rate of incident light.

## Claims

1. A back contact solar cell (100), comprising:
a silicon substrate (1) having a first surface (11) and a second surface (12) opposite to each other, a P-type conductive section (121) and an N-type conductive section (122) spaced apart from each other being provided at a side of the second surface (12) of the silicon substrate (1);
a first passivation layer (5) disposed on the first surface (11) of the silicon substrate (1);
a protective layer (4) disposed on a side of the first passivation layer (5) facing away from the silicon substrate (1), the protective layer (4) comprising a plurality of support members (41) spaced apart from each other and disposed on the side of the first passivation layer (5) facing away from the silicon substrate (1);
a first electrode (2) electrically connected to the P-type conductive section (121); and
a second electrode (3) electrically connected to the N-type conductive section (122);
**characterized in that** a cross-sectional shape of the support members (41), perpendicular to a thickness direction (Z) of the back contact solar cell (100), is a strip shape formed by combining a semicircular shape and a rectangular shape;
the semicircular shape has a radius of R₂, where 0 < R₂ ≤ 2 mm; and
the rectangular shape has a length of L, where 1 ≤ L/R₂ ≤ 5.

2. The back contact solar cell (100) according to claim 1, wherein in a thickness direction (Z) of the back contact solar cell (100), a projected area of the protective layer (4) is 2% to 3% of a projected area of the silicon substrate (1).

3. The back contact solar cell (100) according to claim 1 or claim 2, wherein the protective layer (4) has a thickness of H₁, where 5 µm ≤ H₁ ≤ 60 µm.

4. The back contact solar cell (100) according to any one of claims 1 to 3, wherein a distance between geometric centers of any two adjacent support members (41) is greater than 0 mm and smaller than or equal to 20 mm.

5. The back contact solar cell (100) according to claim 1, wherein the strip shape is formed by one rectangular shape with two semicircular shapes disposed at two opposite ends of the one rectangular shape in a length direction of the one rectangular shape, preferably, the one rectangular shape has a width the same as a diameter of the two semicircular shapes.

6. The back contact solar cell (100) according to any one of claims 1 to 5, wherein the protective layer (4) is a transparent protective layer.

7. The back contact solar cell (100) according to any one of claims 1 to 6, wherein a material of the protective layer (4) is acrylic resin, epoxy resin, polyurethane, silicone, or any combination thereof.

8. The back contact solar cell (100) according to any one of claims 1 to 7, further comprising:
a first doped conductive layer (6) disposed in the P-type conductive section (121) at the second surface (12) of the silicon substrate (1);
a second doped conductive layer (7) disposed in the N-type conductive section (122) at the second surface (12) of the silicon substrate (1); and
a second passivation layer (8) disposed on a side of the first doped conductive layer (6) and a side of the second doped conductive layer (7) that face away from the silicon substrate (1), and disposed on at least a portion of the second surface (12);
optionally, the first doped conductive layer (6) forms a PN junction structure with the silicon substrate (1);
optionally, each of the second doped conductive layer (7) and the silicon substrate (1) contains a doping element, and a concentration gradient of the doping element is formed between the second doped conductive layer (7) and the silicon substrate (1);
optionally, the first electrode (2) penetrates through the second passivation layer (8) to be electrically connected to the first doped conductive layer (6), and the second electrode (3) penetrates through the second passivation layer (8) to be electrically connected to the second doped conductive layer (7).

9. The back contact solar cell according to claim 8, further comprising:
a first tunneling dielectric layer (10a) disposed between the first doped conductive layer (6) and the silicon substrate (1); and
a second tunneling dielectric layer (10b) disposed between the second doped conductive layer (7) and the silicon substrate (1).

10. The back contact solar cell according to claim 8 or claim 9, further comprising an anti-reflection layer (9) disposed between the first passivation layer (5) and the protective layer (4); preferably, a thickness between a surface of the second passivation layer (8) facing away from the silicon substrate (1) and a surface of the first passivation layer (5) or the anti-reflection layer (9) facing away from the silicon substrate (1) is 90 µm to 210 µm.

11. A photovoltaic module, comprising:
a cell string (110) formed by a plurality of back contact solar cells connected to each other, wherein each of the plurality of back contact solar cells is the back contact solar cell (100) of any one of claims 1 to 10;
an encapsulation layer (120) configured to cover a surface of the protective layer (4) of each of the plurality of back contact solar cells of the cell string (110); and
a cover plate (130) configured to cover a surface of the encapsulation layer (120) away from the cell string (110).

## Patentansprüche

1. Rückseitenkontaktierte Solarzelle (100), Folgendes umfassend:
ein Siliziumsubstrat (1), das eine erste Oberfläche (11) und eine zweite Oberfläche (12) aufweist, die einander gegenüberliegen, wobei ein leitfähiger Teilabschnitt der P-Art (121) und ein leitfähiger Teilabschnitt der N-Art (122) voneinander beabstandet sind, wobei sie auf einer Seite der zweiten Oberfläche (12) des Siliziumsubstrats (1) bereitgestellt sind;
eine erste Passivierungsschicht (5), die auf der ersten Oberfläche (11) des Siliziumsubstrats (1) angeordnet ist;
eine Schutzschicht (4), die auf einer von dem Siliziumsubstrat (1) abgewandten Seite der ersten Passivierungsschicht (5) angeordnet ist, wobei die Schutzschicht (4) eine Vielzahl von voneinander beabstandeten und auf der von dem Siliziumsubstrat (1) abgewandten Seite der ersten Passivierungsschicht (5) angeordneten Stützelementen (41) umfasst;
eine erste Elektrode (2), die elektrisch mit dem leitfähigen Teilabschnitt der P-Art (121) verbunden ist; und
eine zweite Elektrode (3), die elektrisch mit dem leitfähigen Teilabschnitt der N-Art (122) verbunden ist;
**dadurch gekennzeichnet, dass** eine Querschnittsform der Stützelemente (41) senkrecht zu einer Dickenrichtung (Z) der rückseitenkontaktierten Solarzelle (100) eine Streifenform ist, die durch Kombinieren einer halbkreisförmigen Form und einer rechteckigen Form ausgebildet ist;
wobei die halbkreisförmige Form einen Radius von R₂ aufweist, wobei 0 < R₂ ≤ 2 mm; und
die rechteckige Form eine Länge von L aufweist, wobei 1 ≤ L/R₂ ≤ 5.

2. Rückseitenkontaktierte Solarzelle (100) nach Anspruch 1, wobei in einer Dickenrichtung (Z) der rückseitenkontaktierten Solarzelle (100) eine projizierte Fläche der Schutzschicht (4) 2 % bis 3 % einer projizierten Fläche des Siliziumsubstrats (1) ist.

3. Rückseitenkontaktierte Solarzelle (100) nach Anspruch 1 oder Anspruch 2, wobei die Schutzschicht (4) eine Dicke von H₁ aufweist, wobei 5 µm ≤ H₁ ≤ 60 µm.

4. Rückseitenkontaktierte Solarzelle (100) nach einem der Ansprüche 1 bis 3, wobei ein Abstand zwischen geometrischen Mittelpunkten zweier beliebiger benachbarter Stützelemente (41) größer als 0 mm und kleiner oder gleich 20 mm ist.

5. Rückseitenkontaktierte Solarzelle (100) nach Anspruch 1, wobei die Streifenform durch eine rechteckige Form ausgebildet ist, mit zwei halbkreisförmigen Formen, die an zwei gegenüberliegenden Enden der einen rechteckigen Form in einer Längsrichtung der einen rechteckigen Form angeordnet sind, wobei die eine rechteckige Form vorzugsweise eine Breite aufweist, die gleich einem Durchmesser der zwei halbkreisförmigen Formen ist.

6. Rückseitenkontaktierte Solarzelle (100) nach einem der Ansprüche 1 bis 5, wobei die Schutzschicht (4) eine transparente Schutzschicht ist.

7. Rückseitenkontaktierte Solarzelle (100) nach einem der Ansprüche 1 bis 6, wobei ein Material der Schutzschicht (4) Acrylharz, Epoxidharz, Polyurethan, Silikon oder eine beliebige Kombination davon ist.

8. Rückseitenkontaktierte Solarzelle (100) nach einem der Ansprüche 1 bis 7, ferner Folgendes umfassend:
eine erste dotierte leitfähige Schicht (6), die in dem leitfähigen Teilabschnitt der P-Art (121) an der zweiten Oberfläche (12) des Siliziumsubstrats (1) angeordnet ist;
eine zweite dotierte leitfähige Schicht (7), die in dem leitfähigen Teilabschnitt der N-Art (122) an der zweiten Oberfläche (12) des Siliziumsubstrats (1) angeordnet ist; und
eine zweite Passivierungsschicht (8), die auf einer Seite der ersten dotierten leitfähigen Schicht (6) und einer Seite der zweiten dotierten leitfähigen Schicht (7) angeordnet ist, die von dem Siliziumsubstrat (1) abgewandt sind, und die auf mindestens einem Abschnitt der zweiten Oberfläche (12) angeordnet ist;
wobei optional die erste dotierte leitfähige Schicht (6) eine PN-Übergangsstruktur mit dem Siliziumsubstrat (1) ausbildet;
wobei optional jedes von dem zweiten dotierten leitfähigen Schicht (7) und dem Siliziumsubstrat (1) ein Dotierungselement enthält, und ein Konzentrationsgradient des Dotierungselements zwischen der zweiten dotierten leitfähigen Schicht (7) und dem Siliziumsubstrat (1) ausgebildet ist;
wobei optional die erste Elektrode (2) die zweite Passivierungsschicht (8) durchdringt, um mit der ersten dotierten leitfähigen Schicht (6) elektrisch verbunden zu sein, und die zweite Elektrode (3) die zweite Passivierungsschicht (8) durchdringt, um mit der zweiten dotierten leitfähigen Schicht (7) elektrisch verbunden zu sein.

9. Rückseitenkontaktierte Solarzelle nach Anspruch 8, ferner Folgendes umfassend:
eine erste dielektrische Tunnelschicht (10a), die zwischen der ersten dotierten leitfähigen Schicht (6) und dem Siliziumsubstrat (1) angeordnet ist; und
eine zweite dielektrische Tunnelschicht (10b), die zwischen der zweiten dotierten leitfähigen Schicht (7) und dem Siliziumsubstrat (1) angeordnet ist.

10. Rückseitenkontaktierte Solarzelle nach Anspruch 8 oder Anspruch 9, ferner umfassend eine Antireflexionsschicht (9), die zwischen der ersten Passivierungsschicht (5) und der Schutzschicht (4) angeordnet ist; wobei vorzugsweise eine Dicke zwischen einer Oberfläche der zweiten Passivierungsschicht (8), die von dem Siliziumsubstrat (1) abgewandt ist, und einer Oberfläche der ersten Passivierungsschicht (5) oder der Antireflexionsschicht (9), die von dem Siliziumsubstrat (1) abgewandt sind, 90 µm bis 210 µm ist.

11. Fotovoltaisches Modul, Folgendes umfassend:
einen Zellstrang (110), der durch eine Vielzahl von rückseitenkontaktierten Solarzellen ausgebildet ist, die miteinander verbunden sind, wobei jede der Vielzahl von rückseitenkontaktierten Solarzellen die rückseitenkontaktierte Solarzelle (100) nach einem der Ansprüche 1 bis 10 ist;
eine Verkapselungsschicht (120), die konfiguriert ist, eine Oberfläche der Schutzschicht (4) jeder der Vielzahl von rückseitenkontaktierten Solarzellen des Zellstrangs (110) abzudecken; und
eine Abdeckplatte (130), die konfiguriert ist, eine von dem Zellstrang (110) entfernte Oberfläche der Verkapselungsschicht (120) abzudecken.

## Revendications

1. Cellule solaire à contact arrière (100), comprenant :
un substrat de silicium (1) ayant une première surface (11) et une seconde surface (12) opposées l'une à l'autre, une section conductrice de type P (121) et une section conductrice de type N (122) espacées l'une de l'autre étant prévues au niveau d'un côté de la seconde surface (12) du substrat de silicium (1) ;
une première couche de passivation (5) disposée sur la première surface (11) du substrat de silicium (1) ;
une couche protectrice (4) disposée sur un côté de la première couche de passivation (5) faisant face à l'opposé du substrat de silicium (1), la couche protectrice (4) comprenant une pluralité d'éléments de support (41) espacés les uns des autres et disposés sur le côté de la première couche de passivation (5) faisant face à l'opposé du substrat de silicium (1) ;
une première électrode (2) connectée électriquement à la section conductrice de type P (121) ; et
une seconde électrode (3) connectée électriquement à la section conductrice de type N (122) ;
**caractérisée en ce qu'**une forme en coupe transversale des éléments de support (41), perpendiculaire à une direction d'épaisseur (Z) de la cellule solaire à contact arrière (100), est une forme de bande formée en combinant une forme semi-circulaire et une forme rectangulaire ;
la forme semi-circulaire a un rayon de R₂, où 0 < R₂ ≤ 2 mm ; et
la forme rectangulaire a une longueur de L, où 1 ≤ L/R₂ ≤ 5.

2. Cellule solaire à contact arrière (100) selon la revendication 1, dans laquelle, dans une direction d'épaisseur (Z) de la cellule solaire à contact arrière (100), une zone projetée de la couche protectrice (4) représente 2 % à 3 % de la zone projetée du substrat de silicium (1).

3. Cellule solaire à contact arrière (100) selon la revendication 1 ou la revendication 2, dans laquelle la couche protectrice (4) a une épaisseur de H₁, où 5 µm ≤ H₁ ≤ 60 µm.

4. Cellule solaire à contact arrière (100) selon l'une quelconque des revendications 1 à 3, dans laquelle une distance entre les centres géométriques de deux éléments de support (41) adjacents quelconques est supérieure à 0 mm et inférieure ou égale à 20 mm.

5. Cellule solaire à contact arrière (100) selon la revendication 1, dans laquelle la forme de bande est formée d'une forme rectangulaire avec deux formes semi-circulaires disposées au niveau de deux extrémités opposées de la forme rectangulaire selon une direction longitudinale de la forme rectangulaire, de préférence, la forme rectangulaire a une largeur égale à un diamètre des deux formes semi-circulaires.

6. Cellule solaire à contact arrière (100) selon l'une quelconque des revendications 1 à 5, dans laquelle la couche protectrice (4) est une couche protectrice transparente.

7. Cellule solaire à contact arrière (100) selon l'une quelconque des revendications 1 à 6, dans laquelle un matériau de la couche protectrice (4) est une résine acrylique, une résine époxy, du polyuréthane, du silicone ou toute combinaison de ceux-ci.

8. Cellule solaire à contact arrière (100) selon l'une quelconque des revendications 1 à 7, comprenant en outre :
une première couche conductrice dopée (6) disposée dans la section conductrice de type P (121) au niveau de la seconde surface (12) du substrat de silicium (1) ;
une seconde couche conductrice dopée (7) disposée dans la section conductrice de type N (122) au niveau de la seconde surface (12) du substrat de silicium (1) ; et
une seconde couche de passivation (8) disposée sur un côté de la première couche conductrice dopée (6) et sur un côté de la seconde couche conductrice dopée (7) qui font face à l'opposé du substrat de silicium (1), et disposée sur au moins une partie de la seconde surface (12) ;
éventuellement, la première couche conductrice dopée (6) forme une structure de jonction PN avec le substrat de silicium (1) ;
éventuellement, chacune de la seconde couche conductrice dopée (7) et du substrat de silicium (1) contient un élément dopant, et un gradient de concentration de l'élément dopant est formé entre la seconde couche conductrice dopée (7) et le substrat de silicium (1) ;
éventuellement, la première électrode (2) pénètre à travers la seconde couche de passivation (8) pour être connectée électriquement à la première couche conductrice dopée (6), et la seconde électrode (3) pénètre à travers la seconde couche de passivation (8) pour être connectée électriquement à la seconde couche conductrice dopée (7).

9. Cellule solaire à contact arrière selon la revendication 8, comprenant en outre :
une première couche diélectrique tunnel (10a) disposée entre la première couche conductrice dopée (6) et le substrat de silicium (1) ; et
une seconde couche diélectrique tunnel (10b) disposée entre la seconde couche conductrice dopée (7) et le substrat de silicium (1).

10. Cellule solaire à contact arrière selon la revendication 8 ou la revendication 9, comprenant en outre une couche antireflet (9) disposée entre la première couche de passivation (5) et la couche protectrice (4) ; de préférence, une épaisseur entre une surface de la seconde couche de passivation (8) faisant face à l'opposé du substrat de silicium (1) et une surface de la première couche de passivation (5) ou de la couche antireflet (9) faisant face à l'opposé du substrat de silicium (1) est de 90 µm à 210 µm.

11. Module photovoltaïque, comprenant :
une chaîne de cellules (110) formée par une pluralité de cellules solaires à contact arrière connectées entre elles, dans lequel chacune de la pluralité de cellules solaires à contact arrière est la cellule solaire à contact arrière (100) selon l'une des revendications 1 à 10 ;
une couche d'encapsulation (120) configurée pour recouvrir une surface de la couche protectrice (4) de chacune de la pluralité de cellules solaires à contact arrière de la chaîne de cellules (110) ; et
une plaque de recouvrement (130) configurée pour recouvrir une surface de la couche d'encapsulation (120) à l'opposé de la chaîne de cellules (110).
